# EUROPEAN PATENT APPLICATION

(11) **EP 4 635 735 A1**
(43) Date of publication of application: **22.10.2025**
(21) Application number: 23903187.5
(22) Date of filing: 14.11.2023
(51) Int. Cl.: B32B 25/20, B32B 27/00, C08L 83/04, C09J 7/38, C09J 183/04

(54) **THERMALLY CONDUCTIVE COMPOSITE SILICONE RUBBER SHEET**

(30) Priority: 13.12.2022 JP 2022198881
(71) Applicant: SHIN-ETSU CHEMICAL CO., LTD., Tokyo 1000005 (JP)
(72) Inventor: TSUKADA Junichi, Annaka-shi, Gunma 379-0224 (JP); ENDO Akihiro, Annaka-shi, Gunma 379-0224 (JP)
(74) Representative: Schicker, Silvia
(86) International application number: PCT/JP2023/040972
(87) International publication number: WO 2024/127889

(57) **Abstract**

The present invention provides a thermally conductive composite silicone rubber sheet including a thermally conductive silicone rubber sheet and a thermosoftening silicone resin layer provided on one side or both sides of the thermally conductive silicone rubber sheet and having a thickness of 0.5 to 10 µm and an absolute viscosity of 10 to 700 Pa·s at 70°C. The thermosoftening silicone resin layer includes (A) 75 to 95% by mass of a thermosoftening silicone resin in which the proportion of phenyl groups to the number of all substituents directly bonded to silicon atoms is 20 mol% or more, and (B) 5 to 25% by mass of a diphenylsiloxy group-containing organopolysiloxane represented by the following formula (1): 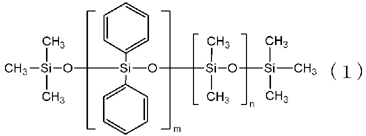 wherein m is an integer of 3 to 5, and n is an integer of 5 to 12. Thus, a thermally conductive composite silicone rubber sheet that can develop adhesiveness on instantaneous contact while suppressing oil bleed can be provided.

## Description

### TECHNICAL FIELD

The present invention relates to a thermally conductive composite silicone rubber sheet provided between a heat-generating component and a heat-dissipating component in an electronic device and used for heat dissipation.

### BACKGROUND ART

Conventionally, heat sinks made of metal plates with high thermal conductivity, such as aluminum and copper, have been used in electronic devices and the like in order to suppress a temperature rise of semiconductors during operation. The semiconductor and the heat sink must be electrically insulated from each other, and it is known that both insulation and thermal conductivity can be achieved by using a thermally conductive silicone rubber sheet in which a polymer such as silicone is filled with a thermally conductive filler to impart thermal conductivity.

When a thermally conductive silicone rubber sheet is mounted between a heat generator such as a semiconductor and a cooling plate such as a heat sink, the thermally conductive silicone rubber sheet is fixed with screws, spring clips, or the like. However, due to process issues during mounting, the thermally conductive silicone rubber sheet is required to be adhesive on at least one side. This is because it is necessary to align the mounting points of the thermally conductive silicone rubber sheet during mounting. Without an adhesive layer, the desired mounting points may be displaced during fixing. In addition, in some circumstances in the mounting process, the thermally conductive silicone rubber sheet must be attached vertically.

Applying an adhesive layer to a thermally conductive silicone rubber sheet is a known technique, and measures for the mounting process have been taken by applying an adhesive layer (Patent Documents 1, 2, and 3). However, the conventional adhesive layers applied to thermally conductive silicone rubber sheets have a thickness of approximately 10 to 50 µm, and the large thickness of the adhesive layers significantly deteriorates thermal conductivity. If the thickness of the adhesive layer is reduced in an attempt to improve thermal conductivity, thermal conductivity is indeed improved, but adhesive strength is reduced. It may be possible to impart thermal conductivity to the adhesive layer itself, but a thermal conductive filler needs to be added in order to impart thermal conductivity to the adhesive layer. This also causes reduction in adhesive strength. The thickness of the adhesive layer may be increased in order to ensure adhesive strength, but increasing the thickness of the adhesive layer sacrifices thermal conductivity. In this way, there is a trade-off between adhesive strength and thermal conductivity, and a method to impart adhesive strength without sacrificing thermal conductivity as much as possible has been needed for years.

Patent Document 4 proposes a thermally conductive composite silicone rubber sheet having a thermosoftening silicone resin layer with a thickness of 0.5 to 10 µm to achieve both adhesive strength and heat dissipation performance as well as their long-term reliability. However, in order to allow the thermally conductive silicone rubber sheet to sufficiently adhere to an adherend to prevent it from peeling off or falling off, the process of pressure-bonding for a few to a few tens of seconds is essential when attaching the sheet. To shorten the process during their assembly operation, it is essential to improve tackiness, which is generally expressed as adhesiveness that develops on instantaneous contact.

### CITATION LIST

### PATENT LITERATURE

Patent Document 1: JP 2014-193598 A
Patent Document 2: JP 2018-193491 A
Patent Document 3: WO 2018/070351 A1
Patent Document 4: JP 2020-203457 A

### SUMMARY OF INVENTION

### TECHNICAL PROBLEM

The present invention is made in view of such circumstances, and an object of the present invention is to provide a thermally conductive composite silicone rubber sheet that has a thermosoftening silicone resin layer on one side or both sides of a thermally conductive silicone rubber sheet and can develop adhesiveness on instantaneous contact while suppressing oil bleed.

### SOLUTION TO PROBLEM

To solve the above problem, the present invention provides a thermally conductive composite silicone rubber sheet including:
a thermally conductive silicone rubber sheet; and
a thermosoftening silicone resin layer provided on one side or both sides of the thermally conductive silicone rubber sheet, the thermosoftening silicone resin layer having a thickness of 0.5 to 10 µm and an absolute viscosity of 10 to 700 Pa·s at 70°C,
wherein the thermosoftening silicone resin layer includes:
   (A) 75 to 95% by mass of a thermosoftening silicone resin in which a proportion of phenyl groups to a number of all substituents directly bonded to silicon atoms is 20 mol% or more; and
   (B) 5 to 25% by mass of a diphenylsiloxy group-containing organopolysiloxane represented by the following formula (1): 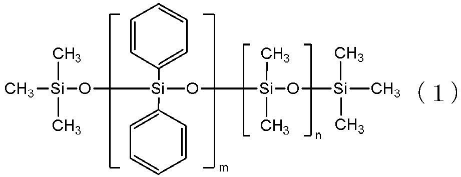
wherein m is an integer of 3 to 5, and n is an integer of 5 to 12.

With the thermally conductive composite silicone rubber sheet having such a thermosoftening silicone resin layer, the compatibility between the silicone rubber component of the thermally conductive silicone rubber sheet and the resin component (component (A)) of the thermosoftening silicone resin layer is not too high, thereby suppressing reduction in adhesive strength during storage due to dispersion of the resin component of the thermosoftening silicone resin layer into the thermally conductive silicone rubber sheet. As a result, adhesiveness can develop on instantaneous contact. Furthermore, the diphenylsiloxy group-containing organopolysiloxane which is the component (B) can be properly retained in the resin layer, thereby suppressing oil bleed to the outside.

It is preferable that the component (A) is a thermosoftening silicone resin represented by the following formula (2) or (3):

DₚT^{φ}_{q}D^{Vi}ᵣ (2)

wherein D represents a dimethylsiloxane unit: (CH₃)₂SiO_{2/2}, T^{φ} represents a phenylsiloxane unit: (C₆H₅)SiO_{3/2}, D^{Vi} represents a methylvinylsiloxane unit: (CH₃)(CH₂=CH)SiO_{2/2}, and p, q, and r satisfy (p + r)/q (molar ratio) = 0.25 to 4.0, and (p + r)/r (molar ratio) = 1.0 to 4.0,

M_{L}DₚT^{φ}_{q}D^{Vi}ᵣ (3)

wherein M represents a trimethylsiloxane unit: (CH₃)₃SiO_{1/2}, D, T^{φ}, and D^{Vi} are as defined above, and p, q, r, and L satisfy (p + r)/q (molar ratio) = 0.25 to 4.0, (p + r)/r (molar ratio) = 1.0 to 4.0, and L/(p + r) (molar ratio) = 0.001 to 0.1.

When the thermosoftening silicone resin which is the component (A) is as described above, adhesiveness can develop on instantaneous contact.

It is preferable that the thermosoftening silicone resin layer has a tackiness of 2.0 N/cm² or higher as measured by a probe tack test according to ASTM D2979.

If the tackiness is 2.0 N/cm² or higher, fixing to an adherend is possible without applying another pressure.

It is preferable that the thermally conductive silicone rubber sheet includes a silicone rubber component including a dimethylsiloxane unit.

In this way, the thermally conductive silicone rubber sheet preferably includes a silicone rubber component including a dimethylsiloxane unit, that is, a dimethyl silicone rubber.

With such a thermally conductive silicone rubber sheet, the diffusion of the diphenylsiloxy group-containing organopolysiloxane, which is the component (B) of the thermosoftening silicone resin layer, can be suppressed.

It is preferable that the thermally conductive silicone rubber sheet contains a glass cloth and/or a plastic film.

The thermally conductive silicone rubber sheet containing a glass cloth has high strength. The thermally conductive silicone rubber sheet containing a plastic film has higher electrical insulation.

In this case, it is preferable that the thermally conductive silicone rubber sheet has a Type A hardness of 50 to 100 as measured by a method according to JIS K6253:2012.

Within this range, change in thickness and cracking of the thermally conductive silicone rubber sheet can be suppressed and stable insulation can be maintained.

### ADVANTAGEOUS EFFECTS OF INVENTION

As described above, the thermally conductive composite silicone rubber sheet according to the present invention can develop adhesiveness on instantaneous contact while suppressing oil bleed, and when mounted at the interface between a heat generator and a cooling member, for example, the thermally conductive composite silicone rubber sheet can adhere to an adherend simply by contact. This leads to reduction in process time and significant improvement in production efficiency.

### DESCRIPTION OF EMBODIMENTS

As described above, it has been demanded to develop a thermally conductive composite silicone rubber sheet that has an adhesive layer on one side or both sides of a thermally conductive silicone rubber sheet and can develop adhesiveness on instantaneous contact while suppressing oil bleed.

The inventors of the present invention have conducted elaborate studies on the above problem and found that a thermally conductive composite silicone rubber sheet in which a thermosoftening silicone resin layer containing (A) 75 to 95% by mass of a thermosoftening silicone resin in which the proportion of phenyl groups to the number of all substituents directly bonded to silicon atoms is 20 mol% or more, and (B) 5 to 25% by mass of a diphenylsiloxy group-containing organopolysiloxane represented by the above formula (1), and having a thickness of 0.5 to 10 µm and an absolute viscosity of 10 to 700 Pa·s at 70°C, is provided on one side or both sides of a thermally conductive silicone rubber sheet can develop adhesiveness on instantaneous contact while suppressing oil bleed. This finding has led to completion of the invention.

More specifically, the present invention provides a thermally conductive composite silicone rubber sheet including:
a thermally conductive silicone rubber sheet; and
a thermosoftening silicone resin layer provided on one side or both sides of the thermally conductive silicone rubber sheet, the thermosoftening silicone resin layer having a thickness of 0.5 to 10 µm and an absolute viscosity of 10 to 700 Pa·s at 70°C,
wherein the thermosoftening silicone resin layer includes:
   (A) 75 to 95% by mass of a thermosoftening silicone resin in which a proportion of phenyl groups to a number of all substituents directly bonded to silicon atoms is 20 mol% or more; and
   (B) 5 to 25% by mass of a diphenylsiloxy group-containing organopolysiloxane represented by the following formula (1): 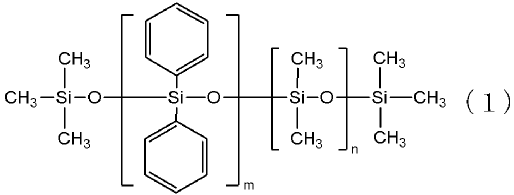
wherein m is an integer of 3 to 5, and n is an integer of 5 to 12.

With such a thermally conductive composite silicone rubber sheet according to the present invention, the compatibility between the silicone rubber component of the thermally conductive silicone rubber sheet and the resin component (component (A)) of the thermosoftening silicone resin layer is not too high, thereby suppressing reduction in adhesive strength during storage due to dispersion of the resin component of the thermosoftening silicone resin layer into the thermally conductive silicone rubber sheet. As a result, adhesiveness can develop on instantaneous contact. Furthermore, the diphenylsiloxy group-containing organopolysiloxane which is the component (B) can be properly retained in the resin layer, thereby suppressing oil bleed to the outside.

The present invention will be described in detail below. However, the present invention is not limited thereto.

### [Thermally Conductive Silicone Rubber Sheet]

The thermally conductive silicone rubber sheet of the thermally conductive composite silicone rubber sheet according to the present invention is obtained, for example, by adding a thermally conductive filler, a curing agent, and the like to a silicone polymer, kneading the mixture to form the thermally conductive silicone rubber composition, forming the composition into a sheet by any method, and curing the formed sheet. However, the thermally conductive silicone rubber sheet of the thermally conductive composite silicone rubber sheet according to the present invention is not particularly limited and may be any thermally conductive silicone rubber sheet.

The kneading is preferably performed by a kneading method with shear force, such as a planetary mixer, a kneader, or a two-roll mill, but is not particularly limited thereto. Exemplary methods for forming the thermally conductive silicone rubber composition into a sheet include calendering, coating, and extrusion molding, but not particularly limited thereto.

The form of curing of the thermally conductive silicone rubber composition is not particularly limited, but examples include addition-curable silicone rubber by a hydrosilylation reaction, peroxide-curable silicone rubber by a peroxide catalyst, and condensation-curable silicone rubber by a condensation reaction of silanol or the like. Among those, the addition-curable or peroxide-curable silicone rubber is preferred in terms of the time required for curing.

The silicone polymer can be selected as desired according to the physical properties of the desired cured product, but the silicone polymer is preferably a dimethyl silicone polymer in which all substituents other than reaction points such as alkenyl groups, hydrosilyl groups, and hydroxy groups among substituents directly bonded to silicon atoms in the silicone polymer are methyl groups. In other words, the silicone rubber component of the thermally conductive silicone rubber sheet preferably includes a dimethylsiloxane unit. Such a silicone polymer is preferred because the diffusion of the diphenylsiloxy group-containing organopolysiloxane contained in the thermosoftening silicone resin layer described later can be suppressed.

The thermally conductive silicone rubber sheet preferably has a thermal conductivity of 0.8 W/mK or higher and more preferably 1.2 W/mK or higher. With a thermal conductivity of 0.8 W/mK or higher, heat from a heat generator can be sufficiently transferred to a cooling area. The upper limit of the thermal conductivity is not particularly limited. As long as the thermally conductive silicone rubber composition can be formed into a sheet, a higher thermal conductivity is preferred because heat from a heat generator can be transferred more efficiently to a cooling area.

The thermally conductive silicone rubber sheet preferably has a thickness of 0.08 mm or more and 1.2 mm or less. If the thickness is 0.08 mm or more, sufficient insulation can be ensured. If the thickness is 1.2 mm or less, heat from a heat generator can be sufficiently transferred to a cooling area while insulation is ensured.

The thermally conductive silicone rubber sheet may include a glass cloth and/or a plastic film. For example, the thermally conductive silicone rubber sheet may contain a material such as a glass cloth for a reinforcing effect or a plastic film for an insulation effect. For example, the thermally conductive silicone rubber sheet may include two silicone rubber layers and an intermediate layer interposed between them, and the intermediate layer may contain the above material.

The thermally conductive silicone rubber sheet containing a glass cloth has high strength. The thermally conductive silicone rubber sheet containing a plastic film has higher electrical insulation.

The thermally conductive silicone rubber sheet containing a glass cloth and/or a plastic film preferably has a Type A hardness of 50 or higher and 100 or lower as measured by the method described in JIS K6253:2012. If the Type A hardness is 50 or higher, it is possible to suppress instability of insulation due to change in thickness caused by the fixing pressure of screws or clips during mounting of the thermally conductive composite silicone rubber sheet. If the Type A hardness is 100 or lower, cracking of the sheet against folding and bending can be suppressed.

As the thermally conductive silicone rubber sheet, various products are already commercially available. Examples include TC-20CG (Shin-Etsu Chemical Co., Ltd.), TC-30BG (Shin-Etsu Chemical Co., Ltd.), TC-15TAP-2 (Shin-Etsu Chemical Co., Ltd.), TC-20TAG-8 (Shin-Etsu Chemical Co., Ltd.), TC-20TA-1 (Shin-Etsu Chemical Co., Ltd.), TC-20TAG-2 (Shin-Etsu Chemical Co., Ltd.), and TC-20TAP-2 (Shin-Etsu Chemical Co., Ltd.). These are only examples, and the thermally conductive silicone rubber sheet is not limited to these.

### [Thermosoftening Silicone Resin Layer]

The thermosoftening silicone resin layer contains a thermosoftening silicone resin (component (A)). "Thermosoftening" means being solid at room temperature (25°C) but becoming fluid when heated. In other words, when a thermally conductive composite silicone rubber sheet with a thermosoftening silicone resin layer laminated as an adhesive layer on a thermally conductive silicone rubber sheet is mounted, for example, at the interface between a heat generator and a cooling member, the thermosoftening silicone resin layer is softened by heat from the heat generator and becomes fluid, so that contact with an adherend is improved and thermal conductivity becomes high.

More specifically, the thermosoftening silicone resin layer is made of the following components (A) and (B):
(A) 75 to 95% by mass of a thermosoftening silicone resin in which the proportion of phenyl groups to the number of all substituents directly bonded to silicon atoms (hereinafter also referred to as phenyl modification ratio) is 20 mol% or more; and
(B) 5 to 25% by mass of a diphenylsiloxy group-containing organopolysiloxane represented by the following formula (1): 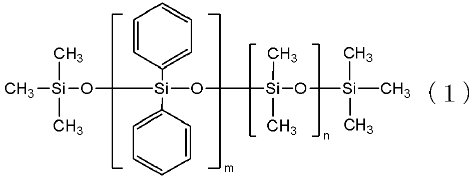 wherein m is an integer of 3 to 5, and n is an integer of 5 to 12.

The thermosoftening silicone resin layer has an absolute viscosity of 10 to 700 Pa·s at 70°C.

The phenyl modification ratio of the component (A) is 20 mol% or more and preferably 30 to 70 mol%. With a phenyl modification ratio of 20 mol% or more, the compatibility between the thermally conductive silicone rubber component having a dimethylsiloxane unit as a main component and the resin component of the thermosoftening silicone resin layer is not too high, thereby suppressing diffusion of the resin component of the thermosoftening silicone resin layer into the thermally conductive silicone rubber sheet.

The thermosoftening silicone resin which is the component (A) is preferably a silicone polymer having a bifunctional structural unit (D unit) and a trifunctional structural unit (T unit), as well as a monofunctional structural unit (M unit), as represented by the following formula (2) or (3), in a certain composition.

DₚT^{φ}_{q}D^{Vi}ᵣ (2)

wherein D represents a dimethylsiloxane unit (i.e. (CH₃)₂SiO_{2/2}), T^{φ} represents a phenylsiloxane unit (i.e. (C₆H₅)SiO_{3/2}), D^{Vi} represents a methylvinylsiloxane unit (i.e. (CH₃)(CH₂=CH)SiO_{2/2}), and p, q, and r satisfy (p + r)/q (molar ratio) = 0.25 to 4.0, and (p + r)/r (molar ratio) = 1.0 to 4.0.

M_{L}DₚT^{φ}_{q}D^{Vi}ᵣ (3)

wherein M represents a trimethylsiloxane unit (i.e. (CH₃)₃SiO_{1/2}), D, T^{φ}, and D^{Vi} are as defined above, and p, q, r, and L satisfy (p + r)/q (molar ratio) = 0.25 to 4.0, (p + r)/r (molar ratio) = 1.0 to 4.0, and L/(p + r) (molar ratio) = 0.001 to 0.1.

One kind of the thermosoftening silicone resin may be used, or two or more kinds may be used in mixture.

The thermosoftening silicone resin layer contains, as the component (B), a diphenylsiloxy group-containing organopolysiloxane represented by the following formula (1) .

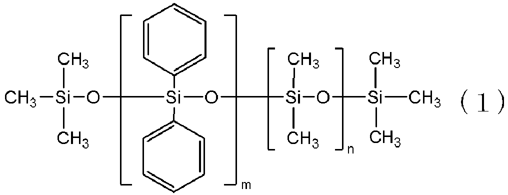

In the formula (1), m is an integer of 3 to 5, and preferably an integer of 4 to 5; n is an integer of 5 to 12, and preferably an integer of 6 to 12; and m + n is preferably in a range of 8 to 17 and more preferably in a range of 10 to 15.

The diphenylsiloxy group-containing organopolysiloxane can be interposed in the softening silicone resin layer without oil bleed, and can maintain the tackiness of the softening silicone resin layer for a long term.

The content of the diphenylsiloxy group-containing organopolysiloxane (B) in the thermosoftening silicone resin layer is 5% by mass or more and 25% by mass or less of the total thermosoftening silicone resin layer, and preferably 10% by mass or more and 20% by mass or less. If the content of the diphenylsiloxy group-containing organopolysiloxane is less than 5% by mass, it is difficult to obtain sufficient tackiness. If the content is greater than 25% by mass, oil may bleed from the thermosoftening silicone resin layer.

The thermosoftening silicone resin layer has an absolute viscosity of 10 Pa·s or higher and 700 Pa·s or lower at 70°C. If the absolute viscosity of the thermosoftening silicone resin layer at 70°C is higher than 700 Pa·s, it is difficult to fully fill a gap between an adherend and the thermosoftening silicone resin layer. If the absolute viscosity is lower than 10 Pa·s, the fluidity is too high and flowing-out or the like may occur.

The absolute viscosity can be measured using a rotational viscometer HAAKE RotoVisco 1. Specifically, a silicone resin sample is placed between a flat disk (20 mm diameter) on the lower side and a cone-shaped disk (20 mm diameter, 2 degree cone angle, 0.1 mm truncation) on the upper side, which are placed horizontally above and below on a vertical central axis, and measured with the flat disk fixed and with the cone-shaped disk rotated around the central axis at a rotational speed of 10 s⁻¹.

The thermosoftening silicone resin layer has a thickness of 0.5 to 10 µm. Preferably, the thickness is 1 to 5 µm. If the thickness is smaller than 0.5 µm, it is impossible to conform to unevenness of an adherend surface and to obtain sufficient adhesion. If the thickness is larger than 10 µm, the thermal resistance of the thermally conductive composite silicone rubber sheet increases.

The softening silicone rubber resin layer of the thermally conductive composite silicone rubber sheet preferably has a tackiness of 2.0 N/cm² or higher, more preferably 2.5 N/cm² or higher, and even more preferably 3.0 N/cm² or higher. If the tackiness is 2.0 N/cm² or higher, sufficient tackiness can be obtained when the thermosoftening silicone rubber resin layer is brought into contact with an adherend, thereby preventing misalignment and falling off. The upper limit of the tackiness is not particularly limited, but the tackiness may be 30 N/cm² or lower.

The tackiness can be measured by a probe tack test method according to ASTM D2979. In this method, a stainless steel probe is brought into contact with the softening silicone rubber resin layer of the fixed thermally conductive composite silicone rubber sheet, and the tackiness can be measured from the maximum load required to pull off the probe.

### EXAMPLES

Hereinafter, the present invention will be specifically described with reference to Examples and Comparative Examples. However, the present invention is not limited thereto.

### [Thermally Conductive Silicone Rubber Sheet]

For the thermally conductive silicone rubber sheet, any of the following 1 or 2 was used.
1. Glass cloth-reinforced thermally conductive silicone rubber sheet made of a dimethyl silicone rubber
   (product name: TC-20TAG-2 from Shin-Etsu Chemical Co., Ltd., thickness 0.2 mm, thermal conductivity 2.0 W/mK, Type A hardness 88, peroxide cured)
2. Glass cloth-reinforced thermally conductive silicone rubber sheet made of a dimethyl silicone rubber
   (product name: TC-20TAG-3 from Shin-Etsu Chemical Co., Ltd., thickness 0.2 mm, thermal conductivity 3.0 W/mK, Type A hardness 88, peroxide cured)

### [Thermosoftening Silicone Resin Layer]

To an 85% solution of (component A) (component (A)) represented by the following formula (4) in xylene, (component B-1) (component (B)) represented by the following formula (5) or (component B-2) represented by the following formula (6) was added, and the mixture was put into a planetary mixer and stirred for 30 minutes at room temperature to obtain a thermosoftening silicone resin composition. The composition was applied to one side of the thermally conductive silicone rubber sheet using a comma coater and dried at 80°C for 10 minutes to remove xylene, resulting in a thermosoftening silicone resin layer. Tables 1 and 2 show the ratio of (component A) and (component B-1) or (component B-2) in the thermosoftening silicone resin layer in each of Examples and each of Comparative Examples.

### (Component A) thermosoftening silicone resin

D₂₅T^{Φ}₅₅D^{Vi}₂₀ (4)

(absolute viscosity at 70°C: 20 Pa·s)

### (Component B-1) diphenylsiloxy group-containing organopolysiloxane (phenyl content: 25 mol%)

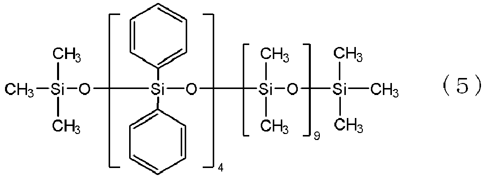

### (Component B-2) dimethylpolysiloxane

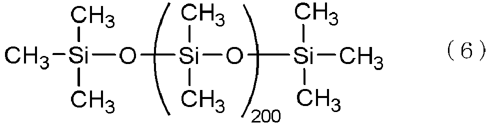

### [Examples 1 to 9]

In Examples 1 to 9, a thermosoftening silicone resin layer was formed on one side of the thermally conductive silicone rubber sheet 1 or 2, with the content (proportion) of (component B-1) in the thermosoftening silicone resin layer varied from 5 to 25% by mass, resulting in a thermally conductive composite silicone rubber sheet of each of Examples 1 to 9. Table 1 shows the proportions of (component A) and (component B-1) in the thermosoftening silicone resin layer and the thickness of the thermosoftening silicone resin layer in each of Examples 1 to 9.

### [Comparative Examples 1 to 5]

In Comparative Examples 1 and 2, a thermosoftening silicone resin layer containing neither (component B-1) nor (component B-2) was formed on one side of the thermally conductive silicone rubber sheet 1 or 2, resulting in a thermally conductive composite silicone rubber sheet of each of Comparative Examples 1 and 2.

In Comparative Examples 3 and 4, a thermosoftening silicone resin layer was formed on one side of the thermally conductive silicone rubber sheet 1 or 2, with the content of (component B-1) in the thermosoftening silicone resin layer set to 30% by mass, resulting in a thermally conductive composite silicone rubber sheet of each of Comparative Examples 3 and 4.

Furthermore, in Comparative Example 5, (component B-1) was not added to the thermosoftening silicone resin, but instead 10% by mass of (component B-2) was added to form a thermosoftening silicone resin layer, resulting in a thermally conductive composite silicone rubber sheet of Comparative Example 5.

Table 2 shows the proportions of (component A), (component B-1), and (component B-2) in the thermosoftening silicone resin layer and the thickness of the thermosoftening silicone resin layer in each of Comparative Examples 1 to 5.

### [Evaluation Method]

### [Thermal Resistance Measurement]

The thermally conductive composite silicone rubber sheets of Examples 1 to 9 and Comparative Examples 1 to 5 obtained as described above were measured using a TIM Tester (from Analysis Tech Inc.) according to ASTM D 6470 at a measurement temperature of 50°C and a pressure of 0.69 N/mm².

### [Tackiness Measurement]

The tackiness of each of the thermosoftening silicone resin layers of the thermally conductive composite silicone rubber sheets prepared in Examples 1 to 9 and Comparative Examples 1 to 5 was measured using a Tackiness Tester TK-1 (from Malcom Co., Ltd.) according to ASTM D 2979 at a measurement temperature of 25°C.

### [Oil Bleed Check]

A 100 µm polyethylene film was attached as a protective film to each of the thermosoftening silicone resin layers of the thermally conductive composite silicone rubber sheets prepared in Examples 1 to 9 and Comparative Examples 1 to 5 and allowed to stand at 25°C for 24 hours. The protective film was then peeled off, and whether an oil component adhered on the protective film side was visually checked.

### [Absolute Viscosity of Thermosoftening Silicone Resin Layer]

The absolute viscosity of each of the thermosoftening silicone resin layers of the thermally conductive composite silicone rubber sheets prepared in Examples 1 to 9 and Comparative Examples 1 to 5 was measured using a rotational viscometer HAAKE RotoVisco 1.

Tables 1 and 2 show the results of these measurements.

**[Table 1]**

| Example | 1 | 2 | 3 | 4 | 5 | 6 | 7 | 8 | 9 |
|---|---|---|---|---|---|---|---|---|---|
| Thermally Conductive Silicone Rubber Sheet | 1 | 1 | 1 | 1 | 1 | 2 | 2 | 2 | 2 |
| Proportion of (Component A) in Thermosoftening silicone resin layer [% by mass] | 95 | 90 | 85 | 80 | 75 | 95 | 90 | 85 | 80 |
| Proportion of (Component B-1) in Thermosoftening Silicone Resin Layer [% by mass] | 5 | 10 | 15 | 20 | 25 | 5 | 10 | 15 | 20 |
| Thickness of Thermosoftening Silicone Resin Laver [µm] | 5 | 5 | 7 | 6 | 4 | 6 | 7 | 5 | 8 |
| Absolute Viscosity of Thermosoftening Silicone Resin Layer at 70°C [Pa·s] | 19 | 17 | 16 | 15 | 13 | 19 | 17 | 16 | 15 |
| Tackiness of Thermosoftening Silicone Resin Laver [N/cm²] | 2.2 | 2.8 | 4.0 | 4.5 | 9.3 | 3.1 | 7.0 | 8.6 | 11.1 |
| Oil Adhesion to Protective Film | None | None | None | None | None | None | None | None | None |
| Thermal Resistance of Thermally Conductive Composite Silicone Rubber Sheet [cm²·K/W] | 1.9 | 2.0 | 1.9 | 2.0 | 1.9 | 1.4 | 1.3 | 1.4 | 1.3 |

**[Table 2]**

| Comparative Example | 1 | 2 | 3 | 4 | 5 |
|---|---|---|---|---|---|
| Thermally Conductive Silicone Rubber Sheet | 1 | 2 | 1 | 2 | 1 |
| Proportion of (Component A) in Thermosoftening Silicone Resin Layer [% by mass] | 100 | 100 | 70 | 70 | 90 |
| Proportion of (Component B-1) in Thermosoftening Silicone Resin Layer [% by mass] | 0 | 0 | 30 | 30 | 0 |
| Proportion of (Component B-2) in Thermosoftening Silicone Resin Layer [% by mass] | 0 | 0 | 0 | 0 | 10 |
| Thickness of Thermosoftening Silicone Resin Laver [µm] | 5 | 5 | 9 | 5 | 5 |
| Absolute Viscosity of Thermosoftening Silicone Resin Laver at 70°C [Pa·s] | 20 | 20 | 7 | 7 | 9 |
| Tackiness of Thermosoftening Silicone Resin Layer [N/cm²] | 1.0 | 1.7 | 14.2 | 14.7 | 3.2 |
| Oil Adhesion to Protective Film | None | None | Present | Present | Present |
| Thermal Resistance of Thermally Conductive Composite Silicone Rubber Sheet [cm²·K/W] | 1.9 | 1.4 | 2.0 | 1.4 | 1.9 |

When the diphenylsiloxy group-containing organopolysiloxane was not added, as in Comparative Examples 1 and 2, the tackiness was 2.0 N/cm² or lower. On the other hand, when the amount of the diphenylsiloxy group-containing organopolysiloxane in the thermosoftening silicone resin layer is greater than 25% by mass, as in Comparative Examples 3 and 4, the tackiness was high, but the diphenylsiloxy group-containing organopolysiloxane oil-bled out of the resin layer and adhered to the protective film. The bleeding oil can cause contamination of electronic devices and contact failure. When dimethylpolysiloxane was added to the thermosoftening silicone resin layer with a phenyl modification ratio of 20 mol% or more, as in Comparative Example 5, the compatibility was poor, and oil adhered to the protective film even when the amount added was 10% by mass.

On the other hand, the thermally conductive composite silicone rubber sheets of Examples 1 to 9 developed a tackiness of 2.0 N/cm² or higher while no oil adhered to the protective film.

The above results show that a thermally conductive composite silicone rubber sheet having excellent tackiness while suppressing oil bleed can be obtained by providing a thermosoftening silicone resin layer containing 75 to 95% by mass of a thermosoftening silicone resin in which the proportion of phenyl groups to the number of all substituents directly bonded to silicon atoms is 20 mol% or more, and containing 5 to 25% by mass of a diphenylsiloxy group-containing organopolysiloxane, with an absolute viscosity of 10 to 700 Pa·s at 70°C and a thickness of 0.5 to 10 µm, on one side or both sides of a thermally conductive silicone rubber sheet.

The thermally conductive composite silicone rubber sheets of Examples 1 to 9 have a thermal resistance of 2.0 cm²·K/W or lower, indicating that they can sufficiently transfer heat from a heat generator to a cooling area when provided between the heat generator and the cooling area.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A thermally conductive composite silicone rubber sheet comprising:
a thermally conductive silicone rubber sheet; and
a thermosoftening silicone resin layer provided on one side or both sides of the thermally conductive silicone rubber sheet, the thermosoftening silicone resin layer having a thickness of 0.5 to 10 µm and an absolute viscosity of 10 to 700 Pa·s at 70°C,
wherein the thermosoftening silicone resin layer comprises:
(A) 75 to 95% by mass of a thermosoftening silicone resin in which a proportion of phenyl groups to a number of all substituents directly bonded to silicon atoms is 20 mol% or more; and
(B) 5 to 25% by mass of a diphenylsiloxy group-containing organopolysiloxane represented by the following formula (1): 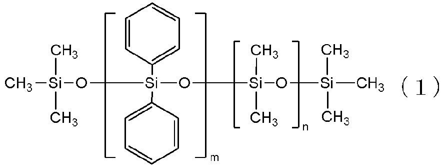
wherein m is an integer of 3 to 5, and n is an integer of 5 to 12.

2. The thermally conductive composite silicone rubber sheet according to claim 1, wherein the component (A) is a thermosoftening silicone resin represented by the following formula (2) or (3):
DₚT^{φ}_{q}D^{Vi}ᵣ (2)
wherein D represents a dimethylsiloxane unit: (CH₃)₂SiO_{2/2}, T^{φ} represents a phenylsiloxane unit: (C₆H₅)SiO_{3/2}, D^{Vi} represents a methylvinylsiloxane unit: (CH₃)(CH₂=CH)SiO_{2/2}, and p, q and r satisfy (p + r) / q (molar ratio) = 0.25 to 4.0, and (p + r) / r (molar ratio) = 1.0 to 4.0,
M_{L}DₚT^{φ}_{q}D^{Vi}ᵣ (3)
wherein M represents a trimethylsiloxane unit: (CH₃)₃SiO_{1/2}, D, T^{φ}, and D^{Vi} are as defined above, and p, q, r and L satisfy (p + r) / q (molar ratio) = 0.25 to 4.0, (p + r) / r (molar ratio) = 1.0 to 4.0, and L / (p + r) (molar ratio) = 0.001 to 0.1.

3. The thermally conductive composite silicone rubber sheet according to claim 1, wherein the thermosoftening silicone resin layer has a tackiness of 2.0 N/cm² or higher as measured by a probe tack test according to ASTM D2979.

4. The thermally conductive composite silicone rubber sheet according to claim 1, wherein the thermally conductive silicone rubber sheet comprises a silicone rubber component comprising a dimethylsiloxane unit.

5. The thermally conductive composite silicone rubber sheet according to claim 1, wherein the thermally conductive silicone rubber sheet comprises a glass cloth and/or a plastic film.

6. The thermally conductive composite silicone rubber sheet according to claim 5, wherein the thermally conductive silicone rubber sheet has a Type A hardness of 50 to 100 as measured by a method according to JIS K6253:2012.
